# EUROPEAN PATENT SPECIFICATION

(11) **EP 0 416 645 B1**
(45) Date of publication and mention of the grant of the patent: **23.12.1998**
(21) Application number: 90117281.7
(22) Date of filing: 07.09.1990
(51) Int. Cl.: H01L 21/00

(54) **Use of cleaning plate for semiconductor fabricating device**
Verwendung einer Reinigungsplatte für Halbleiterherstellungsvorrichtung
Utilisation d'une plaque de nettoyage pour dispositif de fabrication de semi-conducteurs

(30) Priority: 08.09.1989 JP 231649/89
(43) Date of publication of application: 13.03.1991
(73) Proprietor: KABUSHIKI KAISHA TOSHIBA, Kawasaki-shi, Kanagawa-ken 210 (JP)
(72) Inventor: Kamata, Yutaka, Yokohama-shi, Kanagawa-ken (JP)
(74) Representative: Lehn, Werner, Dipl.-Ing.

(56) References cited:
- DE-A- 3 738 957

## Description

### BACKGROUND OF THE INVENTION

### Field of the Invention

This invention relates to the use of a cleaning plate for a semiconductor fabricating device, more particularly, it relates to the use of a cleaning plate for cleaning contact faces of components, such as a conveyer, and a hot plate for heating a wafer, etc., in a semiconductor fabricating device contacted with the surfaces of the semiconductor wafer when it is transferred.

### Description of the Prior Art

In general, a cloth moistened with organic solvent such as alcohol is used in order to remove dust which adhere on contact faces of components (such as a conveyer for transferring a semiconductor wafer, and a hot plate for heating the wafer, etc.) in a semiconductor fabricating device contacted with the surfaces of the semiconductor wafer when it is transferred.

Hereinafter the contact faces of the components are called only "the contact faces".

The dust can be removed by directly wiping on the contact faces with the cloth.

Thereby, the visible dust of more than 100 µm in diameter can be removed by the use of the above mentioned method. But, the dust of approximately 100 µm or less in diameter can not be removed with the cloth.

While there is another method in order to remove the dust of approximately 100 µm in diameter attached on the contact faces, in which method the dust can be eliminated by contacting between the mirror surface of a wafer for cleaning and the contact faces, in this case, only some dust of 10 µm in diameter can be taken off.

When a cleaning wafer has dust on its cleaning surface from previous use and is re-used, the contact surfaces of the components of the semiconductor fabricating device can become further contaminated by the cleaning wafer.

Moreover, a step for cleaning the contact faces is performed repeatedly many times until the contact faces become clean. Thereby, much manufacturing time is required for fabricating the semiconductor device.

On the other hand, according to the progress of a recent processing technique for semiconductors, a processing length of the semiconductor device tends to become more fine. Accordingly, it is necessary to remove as many as possible dusts of 10 µm or less in diameter.

However, a required amount of the dust for keeping the contact faces clean can not be removed by the conventional cleaning method.

As described above, by the conventional cleaning method for the contact faces of the components contacted with the wafer, it is difficult to adequately remove dust of 10 µm or less in diameter attached on the contact faces.

In addition, a plurality of cleaning wafers are required for keeping the contact faces clean by using the conventional cleaning method. Consequently, there is a problem that the manufacturing time for fabricating a semiconductor device is increased by the cleaning process.

### SUMMARY OF THE INVENTION

An object of this invention is to efficiently remove dust attached on contact faces of components, such as a conveyer, and a hot plate etc., in semiconductor fabricating device contacted with the surfaces of a wafer when it is transferred.

According to the invention there is provided the use of a dust-removing plate comprising a dust-removing surface for removing dust from contact faces of components in a semiconductor fabricating device, as given in claim 1.

A preferred cleaning plate further comprises a support layer in the form of a wafer and on at least one surface of which is formed the dust-absorbent layer, which can be made up of a resin or silicon having an absorbability of fine dust.

Moreover, for example the support layer may comprise at least one kind or more of metals, such as a wafer-thin aluminum plate. Alternatively, the support layer may comprise a plastic plate, or a composite material which is made up of a polymeric material or of at least a metal and a polymeric material.

The shape of the cleaning plate may be made equal to the shape of the semiconductor wafer.

The cleaning plate may comprise, for example, a wafer as the support layer and the fine-grained absorbent on the support layer.

The fine-grained absorbent layer is formed on the support layer. When the cleaning plate is transferred on the surface of the components of the semiconductor fabricating device, the fine dust attached on the contact faces of the components can be efficiently removed by the cleaning plate.

Because the shape of the cleaning plate has the same shape as the semiconductor wafer, the cleaning process can be performed by using the transfer process for transferring the semiconductor wafer without adding a new cleaning process or a new cleaning system for cleaning the contact faces of the components in the semiconductor fabricating device.

In preferred embodiments of the invention, dust of more than 0.3 µm in diameter is removed by using the cleaning plate.

When compared with the cleaning wafer of the conventional cleaning means mentioned in the introduction to the specification, the described use of the present cleaning plate can have a cleaning ability of twenty two (22) times than that of the conventional cleaning means.

Accordingly, the frequencies of the cleaning process can be decreased by using the present cleaning plate.

These and other objects, feature and advantages of the present invention will be more apparent from the following description of a preferred embodiment, taken in conjunction with the accompanying drawing.

### BRIEF DESCRIPTION OF THE DRAWINGS

Fig. 1 shows a cleaning plate used in a first embodiment of the invention.
Figs. 2 and 3 show fabricating methods of the cleaning plate as shown in Fig. 1.
Fig. 4 shows a sectional view of a cleaning plate of a second embodiment according to the invention.
Fig. 5 is a fabricating method of the cleaning plate as shown in Fig. 4.
Fig. 6 is a sectional view of a cleaning plate of a third embodiment according to the invention.
Fig. 7 shows a comparison diagram for a cleaning ability between the cleaning means used in the conventional method and the cleaning plate according to the invention.

### DETAILED DESCRIPTION OF THE EMBODIMENTS

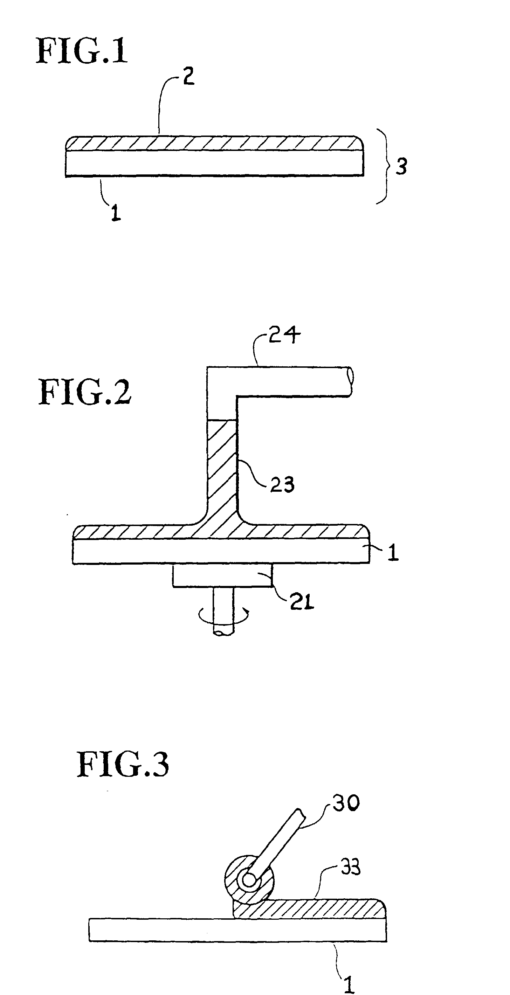

We shall now describe embodiments of a cleaning plate for cleaning contact faces of components (such as a conveyer, and a hot plate for heating a semiconductor wafer, etc.) in a semiconductor fabricating device contacted with the surfaces of the semiconductor wafer when it is transferred according to the invention with reference to Figs. 1 to 7.

Fig. 1 shows a sectional view of a cleaning plate as a first embodiment of this invention.

In the drawing, a numerical number 1 denotes a wafer as a first layer of the cleaning plate. A numeral number 2 designates a fine-dust absorbability means or absorbent as a second layer. The first layer is covered with the second layer 2.

The cleaning plate of the embodiment having above mentioned construction was formed by using a spin coating process as shown in Fig. 2.

In the same drawing, first, the wafer 1 was installed on the spin-chuck 21. The thickness of the wafer 1 was approximately 0.625 mm.

Next, an absorbent 23 was coated on the wafer 1 from a dispense nozzle 24 keeping a rotation of the spin chuck 21 5 at 1,000 to 5,000 r.p.m.

TSE3033 as a Si absorbent No. 1 and TSE3250 as a Si absorbent No. 2 are used as the absorbent 23, TSE3033 and TSE3250 being the tradenames (unregistered) of adhesives manufactured by TOSHIBA SILICON Corp.

The spin coating was performed for approximately 30 to 60 seconds. The thickness of the absorbent 23 formed by using the spin coating method was less than 1 mm.

Moreover, the shape of the cleaning plate 3 was formed to be the same as that of the semiconductor wafer transferred on the transfer surface.

After the spin coating process, the cleaning plate was dried by keeping it in atmosphere for approximately 30 minutes. Then, the cleaning plate was heated at temperature range of 150 to 160 °C. Moreover, as shown in Fig. 3, a coating roller 30 instead of the spinner used in the spin coating method could be used for fabricating the absorbent 23 on the wafer 1. In this case, the drying and heating processes after the fabrication of the absorbent 23 on the wafer 1 were performed just as like the spin coating method as described above.

A dust removable ability of the cleaning plate 3 formed by the above described fabricating process is measured on the contact faces of the components in the semiconductor fabricating device. The cleaning method in which the absorbent 2 is transferred on the contact faces of the components is used for the measurement of the dust removable ability.

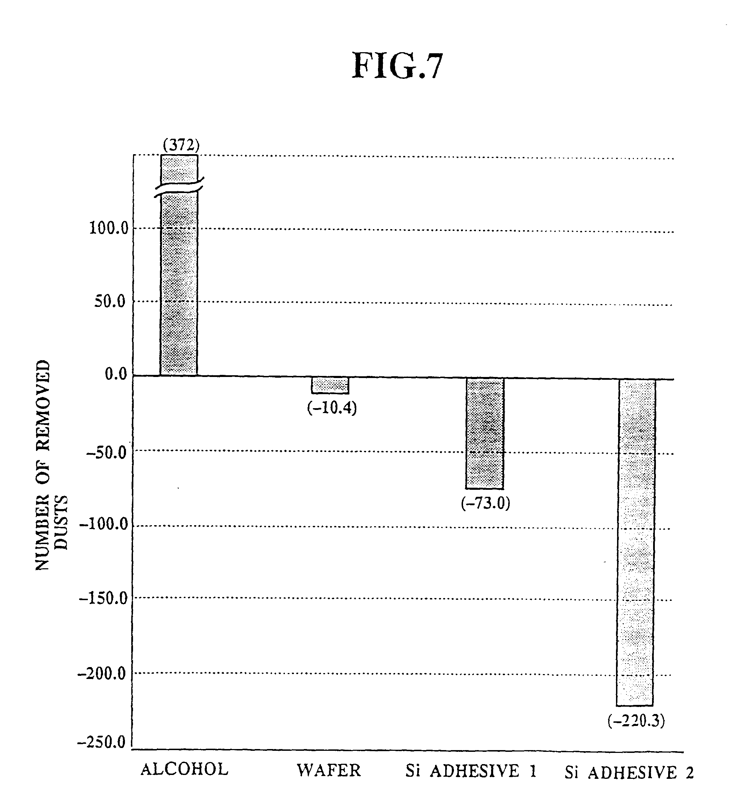

Fig. 7 is a diagram showing the difference of the dust removable ability between the conventional cleaning plate (only a wafer) and the cleaning plate of the present embodiment.

The measurement of the dust on the surface of the conveyer is performed with the dust counter WM-II (manufactured by TOKYO KOUGAKU Corp.).

In the same diagram, the vertical line shows the number of dusts removed by the cleaning plate and the horizontal line shows the type of cleaning material.

Moreover, only the dust more than 0.3 µm can be measured by the dust counter.

In the diagram, when the alcohol is used as the cleaning means, the contact faces of the components are polluted so that the number ofdusts on the contact faces is increased by 372 dusts.

When the wafer is used as the cleaning means, approximately 10 dusts on the contact faces of the components are removed.

When the Si-absorbent 1 (Si-adhesive 1) as the cleaning plate of the present embodiment is used, approximately 70 dusts on the contact faces of the components can be eliminated. In addition, when the Si-absorbent 2 (Si-adhesive 2) as the cleaning plate is used as the cleaning plate, approximately 220 dusts on the contact faces can be removed.

Accordingly, it can be understood that the dust removable ability of the cleaning plate of the embodiment is about 22 times as high as that of the conventional cleaning plate.

Dust of less than 0.3 µm can not be detected by the measurement limitation of the dust counter WM-II.

But it can be assumed that the dust of less than 0.3 µm can be removed with the cleaning plate of the embodiment.

In the above described embodiment, the cleaning plate comprising the wafer and the absorbent formed on the wafer is disclosed.

When a cleaning plate having a construction formed absorbent on the both side of the wafer is used, it can be further eliminated not only the dust on the contact faces of the components but also the atmosphere in the semiconductor fabrication device.

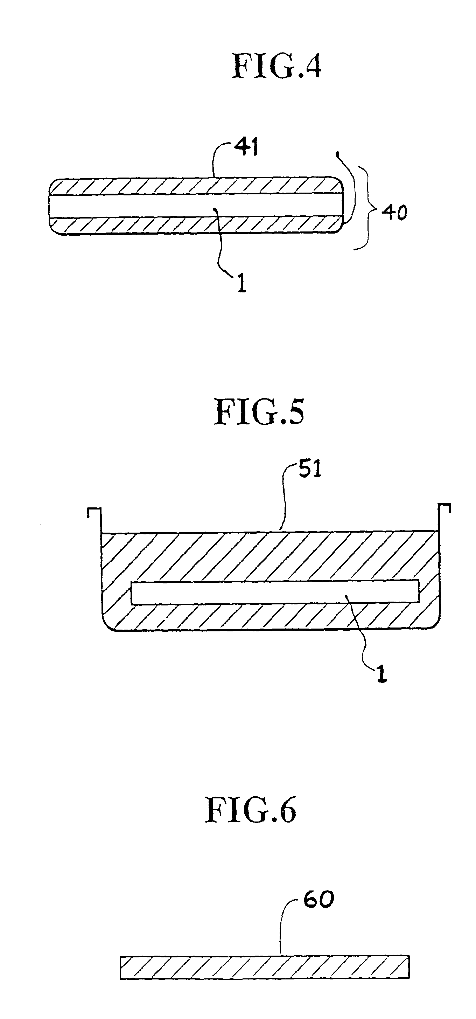

FIg. 4 shows a cross sectional view of a second embodiment of the cleaning plate 40 according to the invention. In the same diagram, a fine-grained absorbent 41 is covered on the both surface of the wafer 1. The shape of the cleaning plate of the second embodiment is formed as same as that of the cleaning plate of the first embodiment.

In the fabrication method of the cleaning plate of the second embodiment, as shown in Fig. 5, for example the wafer 1 is dipped in a melted absorbent 51 for a predetermined time (the dip method).

In the second embodiment as described above, the absorbent is formed on the both surface of the wafer 1. But, the cleaning plate of the third embodiment may be formed only with the absorbent without the wafer.

Fig. 6 is a sectional diagram of a cleaning plate of a third embodiment according to the invention. In the same diagram, the cleaning plate 60 is formed only by the absorbent of the second layer as shown in Fig. 4. In the fabricating method of the cleaning plate of the third embodiment, for example the cleaning plate is fabricated with a rapping plate. The shape of the cleaning plate of the third embodiment is formed as same as that of the cleaning plates of the first and second embodiment as shown in Figs. 1 and 4.

Thus, the dust of less than 10 µm can be eliminated effectively from the transfer surface of the conveyer.

The wafer as the first layer is used in the first and second embodiments.

This invention is not limited to the specific embodiments described above but various modifications are possible without departing from the scope of the invention as

For example, an aluminum plate as a metal plate or a plastic plate as a polymeric material as the first layer can be used for obtaining the same cleaning effect.

Moreover, it is verified by the same test of the first to third embodiments that a cleaning plate with a natural rubber, an acrylic resin or a copolymer of an epoxy resin and a nylon as the second layer has the same cleaning ability.

Accordingly, the second layer is not limited to the type of resin as far as it has the fine-grained absorbability.

Moreover, the shape of the cleaning plate is required to be the same as that of the semiconductor wafer for most efficiently transferring it on the transfer surface of the the conveyor.

However, a cleaning plate having another shape, for example a perfect disk without an orientation flat, can also be used as far as it can be transferred on the contact faces of the components in the semiconductor fabricating device. This can be used without departing from the scope of the invention as defined by the appended claims.

In addition, the cleaning plate of these embodiment according to the invention can withstand use of several times in cleaning operation for the semiconductor fabricating device.

Reference signs in the claims are intended for better understanding and shall not limit the scope.

## Claims

1. The use of a dust-removing plate comprising a dust-removing surface for removing dust from contact faces of components in a semiconductor fabricating device, which faces are to come into contact with the surfaces of a semiconductor wafer in use of the fabricating device,
characterized in that said surface is a surface of a layer (2:60) made up of an absorbent for dust which readily removes dust particles of a size of 10µm or less on contact, said absorbent being selected from Si-adhesive, natural rubber, a resin, or a copolymer of an epoxy resin and a nylon.

2. The use according to claim 1, wherein the dust-removing plate further comprises a support layer (1) which is in the form of a wafer and on at least one surface of which is formed the dust-absorbent layer (2).

3. The use according to claim 1 or 2, wherein the dust-absorbent layer (2) comprises an acrylic resin.

4. The use according to claim 2 or claim 3 as dependent thereon, wherein the support layer (1) comprises at least one kind or more of metals.

5. The use according to claim 2 or claim 3 as dependent thereon, wherein the support layer (1) ccomprises a composite-material which is made up of a polymeric material.

6. The use according to claim 2 or claim 3 as dependent thereon, wherein the support layer (1) comprises a composite material which is made up of at least a metal and a polymeric material.

7. The use according to claim 4, wherein the support layer (1) comprises an aluminium plate.

8. The use according to claim 5, wherein the support layer (1) comprises a plastic plate.

9. The use according to claim 2 or any claim dependent thereon, wherein said dust-absorbent layer (2) is formed on both surfaces of the support surface (1).

10. The use according to any preceding claim, the dust-removing plate having the same shape as that of a semiconductor wafer to be transferred by said contact faces of said components in the semiconductor fabricating device.

## Patentansprüche

1. Verwendung einer staubentfernenden Platte mit einer staubentfernenden Oberfläche zum Entfernen von Staub von Anlageflächen von Komponenten in einer Halbleiterherstellungseinrichtung, derart, daß die Flächen in Kontakt zu den Oberfächen eines in der Halbleitereinrichtung eingesetzten Halbleiterwafers gelangen,
dadurch gekennzeichnet, daß die Oberfläche eine Oberfläche einer Schicht (2; 60) ist, die aus einem Absorptionsmittel für Staub hergestellt ist, das gut Staubpartikel einer Größe von 10 µm oder weniger bei Kontakt entfernt, derart, daß das Absorptionsmittel ausgewählt ist aus einem Si-Klebemittel, Naturkautschuk, einem Harz oder einem Copolymer eines Epoxidharzes mit einem Nylon.

2. Verwendung nach Anspruch 1, dadurch gekennzeichnet, daß die staubentfernende Platte ferner eine Halteschicht (2) enthält, die in der Form eiens Wafers ausgebildet ist und von der mindestens eine Oberfläche als staubabsorbierende Schicht (2) ausgebildet ist.

3. Verwendung nach Anspruch 1 oder 2, dadurch gekennzeichnet, daß die staubabsorbierende Schicht (2) ein Acrylharz enthält.

4. Verwendung nach Anspruch 2 oder 3, soweit rückbezogen hierauf, dadurch gekennzeichnet, daß die Halteschicht (1) mindestens eine Art von oder mehrere Metalle enthält.

5. Verwendung nach Anspruch 2 oder Anspruch 3, soweit rückbezogen hierauf, dadurch gekennzeichnet, daß die Halteschicht (1) einen Verbundwerkstoff enthält, der aus einem Polymermaterial hergestellt ist.

6. Verwendung nach Anspruch 2 oder Anspruch 3, soweit rückbezogen hierauf, dadurch gekennzeichnet, daß die Halteschicht (1) einen Verbundwerkstoff enthält, der aus mindestens einem Metall und einem Polymermaterial hergestellt ist.

7. Verwendung nach Anspruch 4, dadurch gekennzeichnet, daß die Halteschicht (1) eine Aluminiumplatte enthält.

8. Verwendung nach Anspruch 5, dadurch gekennzeichnet, daß die Halteschicht (1) eine Plastikplatte enthält.

9. Verwendung nach Anspruch 2 oder jeden hiervon abhängigen Anspruch, dadurch gekennzeichnet, daß die staubabsorbierende Schicht (2) auf beiden Oberflächen der Haltefläche (1) ausgebildet ist.

10. Verwendung nach einem der vorhergehenden Ansprüche, dadurch gekennzeichnet, daß die staubentfernende Platte dieselbe Form wie diejenige eines Halbleiterwafers aufweist, der durch die Anlageflächen der Komponenten in der Halbleiter-Herstellungseinrichtung zu transportieren ist.

## Revendications

1. Utilisation d'une plaque enlevant la poussière comprenant une surface enlevant la poussière pour enlever la poussière des faces de contact de composants dans un dispositif de fabrication de semi-conducteurs, lesquelles faces vont venir en contact avec les surfaces d'une pastille à semi-conducteurs durant l'utilisation du dispositif de fabrication,
caractérisé en ce que ladite surface est une surface d'une couche (2:60) réalisée à partir d'un absorbant de poussière qui enlève facilement des particules de poussière ayant une taille de 10 µm ou moins qui se trouvent sur le contact, ledit absorbant étant choisi parmi une colle à base de Si, le caoutchouc naturel, une résine, ou un copolymère d'une résine epoxy et d'un nylon.

2. Utilisation selon la revendication 1, dans laquelle la plaque enlevant la poussière comprend en outre une couche de support 1 qui a la forme d'une pastille et sur au moins une surface de laquelle est formée la couche absorbant la poussière (2).

3. Utilisation selon la revendication 1 ou 2, dans laquelle la couche absorbant la poussière (2) comprend une résine acrylique.

4. Utilisation selon la revendication 2, ou la revendication 3 qui en dépend, dans laquelle la couche de support (1) comprend au moins un type de métal ou plusieurs types de métaux.

5. Utilisation selon la revendication 2 ou la revendication 3 qui en dépend, dans laquelle la couche de support (1) comprend une matière composite qui est élaborée à partir d'une matière polymérique.

6. Utilisation selon la revendication 2 ou la revendication 3 qui en dépend, dans laquelle la couche de support (1) comprend une matière composite laquelle est élaborée à partir d'au moins un métal et une matière polymérique.

7. Utilisation selon la revendication 4, dans laquelle la couche de support (1) comprend une plaque d'aluminium.

8. Utilisation selon la revendication 5, dans laquelle la couche de support (1) comprend une plaque en matière plastique.

9. Utilisation selon la revendication 2 ou l'une quelconque des revendications qui en dépend, dans laquelle ladite couche absorbant la poussière (2) est formée sur les deux surfaces de la surface de support (1).

10. Utilisation selon l'une quelconque des revendications précédentes, la plaque enlevant la poussière ayant la même forme que celle d'une pastille à semi-conducteurs devant être transférée dans le dispositif de fabrication de semi-conducteurs par lesdites faces de contact desdits composants.
